# EUROPÄISCHE PATENTANMELDUNG

(11) **EP 0 844 652 A1**
(43) Veröffentlichungstag der Anmeldung: **27.05.1998**
(21) Anmeldenummer: 97118283.7
(22) Anmeldetag: 21.10.1997
(51) Int. Cl.: H01L 21/3205, H01L 29/92, H01L 21/321

(54) **Integrierbarer Kondensator Verfahren zu seiner Herstellung sowie Speicherfeld unter Verwendung des Kondensators**

(30) Priorität: 08.11.1996 DE 19646208
(71) Anmelder: SIEMENS AKTIENGESELLSCHAFT, 80333 München (DE)
(72) Erfinder: Müller, Karlheinz, 84478 Waldkraiburg (DE)

(57) **Zusammenfassung**

Ein Kondensator für eine integrierte Schaltung in Mikrostruktur weist eine erste (1) und eine zweite Elektrode (4) auf, die durch eine dielektrische Schicht (3) getrennt sind. Die dielektrische Schicht (3) wird während des Strukturierens der ersten Elektroden (1) mit einem Ätzverfahren gezielt hergestellt. Die dielektrische Schicht besteht aus einer während des Ätzens gebildeten polymeren Struktur und/oder Ätzprodukten des Elektrodenmetalls. Die erste Elektrode wird vorteilhafterweise zylinderförmig ausgeführt und von der dielektrischen Schicht (3) in Hohlzylinderform umgeben. Die Erfindung betrifft weiterhin ein Verfahren zur Herstellung des Kondensators und ein Speicherfeld, welches mehrere solcher Kondensatoren umfasst.

## Beschreibung

Die Erfindung betrifft einen integrierbaren Kondensator mit einer dielektrischen Schicht und zwei Elektroden, wie er insbesondere bei integrierten Schaltungen mit Mikrostrukturen verwendet wird, sowie ein Verfahren zu seiner Herstellung und ein Speicherfeld, bei dem erfindungsgemäße Kondensatoren verwendet werden.

In integrierten Schaltungen werden Kondensatoren üblicherweise in einer planaren, Trench- oder Stacked-Anordnung ausgeführt. Eingesetzt werden derartige Kondensatoren in Verbindung mit einem Transistor zur Bildung von Speicherzellen in Halbleiterspeichern. Hierbei wird eine Vielzahl von Speicherzellen in einem Speicherfeld angeordnet.

In der Fachwelt ist es bekannt, die dielektrische Schicht, die sich zwischen den elektrisch leitenden Elektrodenmaterialien solcher Kondensatoren befindet, beispielsweise aus SiO₂ oder Si₃N₄ herzustellen. Eine solche dielektrische Schicht weist zwar günstige elektrische Eigenschaften, wie beispielsweise einen hohen Isolationsgrad und eine hohe Dielektrizität, auf, andererseits ist die Herstellung recht aufwendig und erfordert immer zumindest einen zusätzlichen Herstellungsschritt, da die dielektrische Schicht nach der Herstellung der Elektrode auf deren Oberfläche aufgetragen wird.

Der Erfindung liegt die **Aufgabe** zugrunde, einen Kondensator mit einer dielektrischen Schicht und zwei Elektroden - insbesondere für die Verwendung in integrierten Schaltungen mit Mikrostruktur - zu schaffen, welcher eine besonders einfach herzustellende dielektrische Schicht mit guten elektrischen Eigenschaften aufweist. Eine weitere Aufgabe besteht darin, ein Herstellungsverfahren für einen derartigen Kondensator sowie ein Speicherfeld unter Verwendung des Kondensators anzugeben.

Die Aufgabe wird durch den Kondensator gemäß Anspruch 1 gelöst. Verfahrensmäßig gelingt die Lösung der Aufgabe durch das Verfahren des Anspruchs 13. Für das Speicherfeld erfolgt die Lösung der Aufgabe gemäß Anspruch 19.

Vorteilhafte Weiterbildungen sind in den Unteransprüchen beschrieben.

Üblicherweise werden zur Herstellung von strukturierten Oberflächen in integrierten Schaltungen Ätzverfahren eingesetzt. Eine Übersicht über geeignete Ätzverfahren findet sich beispielsweise in D. Widmann, H. Mader und H. Friedrich, Technologie hochintegrierter Schaltungen, 2. Auflage, Springer-Verlag Berlin, 1996, und K. Schade, Mikroelektroniktechnologie, 1. Auflage, Verlag Technik, Berlin, 1991.
Zum Herausätzen von Elektroden aus einer Metallschicht wird beispielsweise auf die Metallschicht ein Maske aus Fotoresist aufgetragen, die die Bereiche, die nicht geätzt werden sollen - d.h. die späteren Elektroden - abdeckt. Der Ätzvorgang selbst erfolgt vorzugsweise mit einem Trockenätzprozeß, um einen anisotropen Ätzverlauf zu erreichen. Die durch das Ätzen freigelegten Oberflächen der Elektroden sind selten rein metallische Oberflächen. Sie weisen vielmehr Ablagerungen von Ätzprodukten auf, die bisher vor der Weiterverarbeitung der Elektroden vollständig entfernt wurden, um metallische Oberflächen zu erhalten. Auf diese metallischen Oberflächen wurde anschließend zur Herstellung von Kondensatoren eine dielektrische Schicht aus Siliciumdioxid, Siliciumnitrid oder ähnlichem aufgebracht.

Erfindungsgemäß wird der Ätzvorgang so ausgeführt, daß beim Herausätzen einer Elektrode aus einer Metallschicht auf den dem Ätzmittel zugänglichen Oberflächen der Elektrode gezielt eine durchgängige dielektrische Schicht gebildet wird, die unmittelbar als Dielektrikum in einem Kondensator dienen kann. Diese dielektrische Schicht besteht aus Ätzprodukten des Metalls und/oder polymeren Strukturen, die sich während des Ätzvorgangs bilden und auf der Elektrodenoberfläche ablagern.

Als Ätzverfahren werden bevorzugt chemische oder physikalisch-chemische Trockenätzverfahren eingesetzt, wie sie beispielsweise grundsätzlich in den oben genannten Literatur-stellen beschrieben sind. Besonders bevorzugt erfolgt das Ätzen durch Plasmaätzen.

Das Ätzmittel, welches vorzugsweise ein Ätzgas ist, wird in Abhängigkeit von der zu ätzenden Struktur und insbesondere in Abhängigkeit von der zu ätzenden Metallschicht gewählt. Jeweils geeignete Ätzmittel sind dem Fachmann grundsätzlich bekannt und beispielsweise ebenfalls in den genannten Literaturstellen aufgeführt.
Die zu ätzenden Metallschichten können beispielsweise im wesentlichen aus Aluminium oder Wolfram bestehen. Im Falle von Aluminium sind fluorhaltige Ätzmittel ungünstig, da sich schwerflüchtige Ätzprodukte bilden.
Grundsätzlich geeignete Ätzmittel sind Halogene wie F₂, Cl₂, Br₂, I₂, Halogenwasserstoffe wie HF, HCl, HBr, HI, Halogenverbindungen des Bors, Siliciums oder Antimons oder halogenierte Kohlenwasserstoffe. Es können jeweils eine einzelne Verbindung oder mehrere Verbindungen jeder der genannten Gruppen verwendet werden oder Mischungen von mehreren Verbindungen der unterschiedlichen Gruppen. Außerdem können die Ätzmittel Zusätze weiterer üblicherweise verwendeter Verbindungen wie z.B. nicht halogenierte Kohlenwasserstoffe enthalten.

Werden Kohlenstoff-haltige Verbindungen und insbesondere halogenierte Kohlenwasserstoffe, gegebenenfalls in Kombination mit anderen beim Ätzen üblicherweise verwendeten Verbindungen, als Ätzgas eingesetzt, entstehen während des Ätzvorgangs auf der Oberfläche der geätzten Metallschicht polymere Strukturen. Im Falle halogenierter Kohlenwasserstoffe bestehen diese beispielsweise aus halogenierten Kohlenstoffketten. Weitere Ätzprodukte, die im Verlauf des Ätzverfahrens gebildet werden, können z.B. Halogenide oder Oxide des geätzten Metalles sein.

Bei der Herstellung der erfindungsgemäßen Kondensatoren wird das Ätzverfahren so durchgeführt, daß auf den geätzten Oberflächen der ersten Elektrode, die aus einer Metallschicht geätzt wird, gezielt eine durchgehende dielektrische Schicht erzeugt wird, die aus einer polymeren Struktur und/oder Ätzprodukten des Metalls besteht.
Die Zusammensetzung der Schicht und damit ihre physikalischchemischen Eigenschaften sowie ihre Schichtdicke werden durch geeignete Wahl des Ätzmittels und der Verfahrensparameter beim Ätzen bestimmt. Auf diese Weise ist eine sehr einfache und gezielte Herstellung der dielektrischen Schicht zwischen einer ersten und einer zweiten Elektrode in einem Kondensator möglich.

Entsprechend einer vorteilhaften Ausführungsform ist die erste Elektrode zylinderförmig und die dielektrische Schicht hohlzylinderförmig auf dem Zylindermantel ausgebildet. Die zylinderförmige Elektrode wird zweckmäßig in einem anisotropen Ätzverfahren hergestellt, bei dem annähernd senkrechte Flankenbereiche der strukturierten Oberflächen erzeugt werden, wobei die Zylinderachse senkrecht zur Oberfläche der Grundstruktur verläuft, auf der die zu ätzende Metallschicht angeordnet war. Mit dieser Anordnung ist die dielektrische Schicht einfach herzustellen, und es wird eine vorteilhafte Anordnung des Kondensators erreicht, welche sich durch gute Kontaktierbarkeit und geringen Platzverbrauch auszeichnet. Um die dielektrische Schicht herum ist die zweite Elektrode ausgebildet.

In einem Speicherfeld, das eine Vielzahl erster Elektroden aufweist, kann die zweite Elektrode als Metallschicht ausgebildet sein, die mehreren oder allen ersten Elektroden als gemeinsame Gegenelektrode dient.
Vorteilhafterweise sind die Kontaktierstellen an den Enden der Elektroden in Richtung der Zylinderachsen angeordnet. Diese Anordnung ergibt vorteilhafte Zuleitungsverläufe zum Kondensator.

Um Kurzschlüsse zwischen den Elektroden zu vermeiden, ist die Höhe der zweiten Elektrode vorzugsweise geringer als die Höhe der ersten Elektrode. Dies kann beispielsweise dadurch erreicht werden, daß die zweite Elektrode so weit abgetragen wird, daß ihre Oberseite tiefer liegt als die Oberseite der ersten Elektrode. Zweckmäßig wird die zweite Elektrode durch Schleifen oder Ätzen abgetragen.

Auf der Oberseite der zweiten Elektrode kann vorteilhaft eine leitende Schicht angeordnet sein. In einer Ausbildungsform der Erfindung besteht die leitende Schicht aus einem Metallsilicid, wie beispielsweise MoSi₂, WSi₂, TaSi₂ oder TiSi₂. Besonders vorteilhaft besitzt diese elektrisch leitende Schicht einen geringeren Widerstand als die zweite Elektrode. Auf der leitenden Schicht kann eine weitere leitende Schicht angeordnet sein. Diese ist niederohmig und besteht beispielsweise aus einem Metall wie Aluminium oder Kupfer. Die untere elektrisch leitende Schicht dient als Barriereschicht für die obere leitende Schicht. Die Schichtstruktur mit unterschiedlichen Widerständen entspricht einer Anordnung mit parallel geschalteten Widerständen.
Es ist erneut vorteilhaft, wenn die Hohe von zweiter Elektrode plus leitender Schicht und gegebenenfalls weiterer leitender Schicht geringer ist als die Höhe der ersten Elektrode.

Die erfindungsgemäßen Kondensatoren können vorteilhaft nach dem Verfahren gemäß Anspruch 13 hergestellt werden. Danach wird zunächst eine Metallschicht auf eine Grundstruktur aufgebracht. Die Grundstruktur kann beispielsweise ein Leiterbahnsystem sein. Diese Metallschicht wird so geätzt, daß eine erste Elektrode entsteht und auf deren dem Ätzen zugänglicher Oberfläche eine polymere Struktur und/oder Ätzprodukte des Metalls als dielektrische Schicht gebildet werden. Anschließend wird eine zweite Elektrode so angebracht, daß erste und zweite Elektroden durch die dielektrische Schicht voneinander getrennt sind.

Gemäß dem erfindungsgemäßen Verfahren zur Herstellung derartiger Kondensatoren wird also eine Metallschicht geätzt und dabei an den geätzten Oberflächen eine dielektrische Schicht ausgebildet, an welche angrenzend eine zweite Elektrode angeordnet wird. Der Kondensator wird somit in lediglich zwei Schritten hergestellt. Damit ist eine erhebliche Zeit- und Kostenersparnis verbunden.

Geeignete Ätzverfahren und Ätzmittel wurden bereits eingangs beschrieben.
Vorteilhafterweise wird die Metallschicht anisotrop geätzt, wobei die dielektrische Schicht an den senkrechten Flanken der ersten Elektrode entsteht.

An die oben genannten Verfahrensschritte kann sich zweckmäßig ein anisotropes Zurückätzen oder Zurückschleifen der zweiten Elektrode anschließen, wobei die Metallschicht der zweiten Elektrode tiefer geätzt wird als die der ersten, um zuverlässig einen Kurzschluß zur ersten Elektrode zu vermeiden. Außerdem kann auf die zweite Elektrode wenigstens eine elektrisch leitende Schicht aufgebracht werden.

Wird eine zusätzliche leitende Schicht auf die leitende Schicht aufgebracht, wird diese wiederum zweckmäßig so lange zurückgeätzt oder zurückgeschliffen, bis der Kontakt zur höheren ersten Elektrode unterbrochen ist. Durch die elektrisch leitende Schichten kann auf sehr einfache Weise eine Kontaktierung von Elektroden hergestellt werden. Verlaufen die elektrisch leitenden Schichten über mehrere Elektroden, läßt sich auf einfache Weise eine elektrische Verbindung zwischen diesen Kondensatorelektroden verwirklichen.

Das erfindungsgemäße Verfahren eignet sich nicht nur zur Herstellung einzelner Kondensatoren, sondern insbesondere zur gleichzeitigen Herstellung mehrer erfindungsgemäßer Kondensatoren, die beispielsweise in einem Speicherfeld, das aus mehreren nebeneinander angeordneten Kondensatoren und üblichen weiteren Bauteilen besteht, angebracht sind.

Derartige Speicherfelder sind ebenfalls Gegenstand der Erfindung. Zur Kontaktierung der zweiten Elektrode, die zweckmäßig eine mehreren ersten Elektroden als Gegenelektrode dienende Metallschicht ist, wird bei einer vorteilhaften Ausführungsform ein Anschlußbereich dadurch gebildet, daß der Abstand zwischen benachbarten ersten Elektroden vergrößert ist, um ausreichend Platz für den Fußpunkt eines Bonddrahtes zu schaffen.

Nachfolgend wird die Erfindung beispielhaft anhand der beigefügten Zeichnungen erläutert. Es zeigen:
- Fig. 1: eine Querschnittsansicht einer integrierten Schaltung vor dem Ätzen von ersten Elektroden;
- Fig. 2: eine Querschnittsansicht einer integrierten Schaltung mit fertig geätzten ersten Elektroden
und den erfindungsgemäßen dielektrischen Schich- ten;
- Fig. 3: eine Querschnittsansicht einer integrierten Schaltung mit aufgebrachter Metallschicht zur Herstellung der zweiten Elektrode;
- Fig. 4: eine Querschnittsansicht einer integrierten Schaltung mit erfindungsgemäßen Kondensatoren;
- Fig. 5: eine Draufsicht auf eine integrierte Schaltung mit erfindungsgemäßen Kondensatoren;
- Fig. 6: eine Draufsicht auf eine integrierte Schaltung mit erfindungsgemäßen Kondensatoren und einem Anschlußfeld und
- Fig. 7: eine Querschnittsansicht entlang der Linie A-A aus Fig. 6.

Die dargestellte Ausführungsform stellt eine integrierte Schaltung in Form einer Anordnung von mehreren Kondensatoren dar, die ein Speicherfeld bilden. Unterhalb der Kondensatoren sind Transistoren angeordnet, die jedoch in den Figuren nicht dargestellt sind.

Im folgenden wird die Herstellung einer integrierten Schaltung mit Mikrostruktur, die erfindungsgemäße Kondensatoren aufweist, dargestellt.

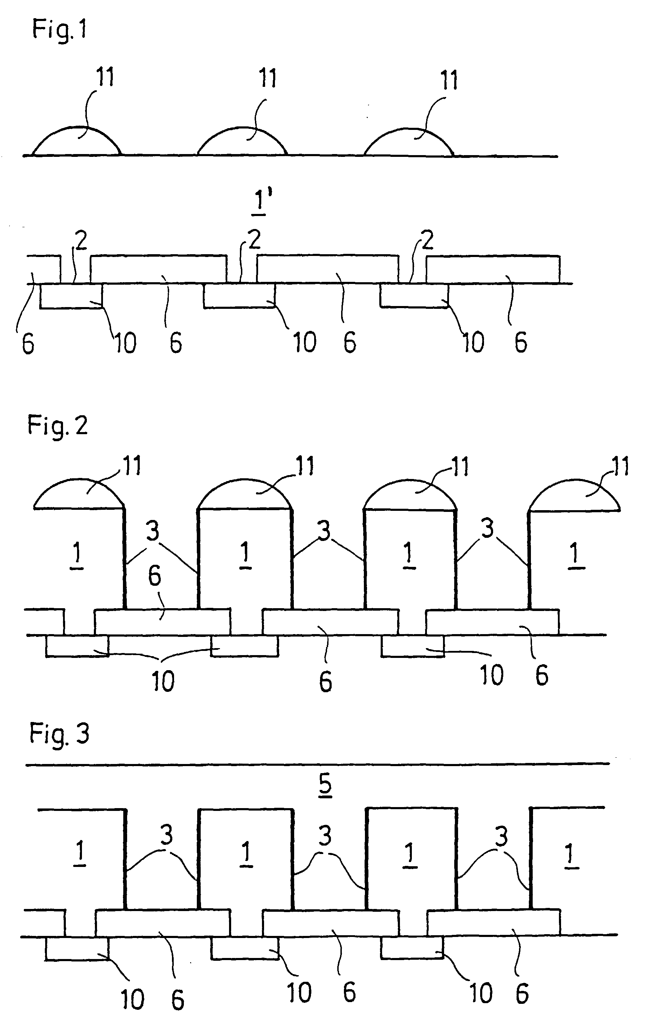

Wie Fig. 1 zeigt, bilden die Leiterbahnen 10 die Grundstruktur einer integrierten Schaltung. Unter ihnen befinden sich weitere Bauteile (nicht dargestellt) wie Transistoren und weitere Leiterbahnen. Es befinden sich drei Leiterbahnen 10 gleichmäßig voneinander beabstandet nebeneinander. Darüber ist als nächste Struktur in den Bereichen zwischen den Leiterbahnen 10 jeweils eine dielektrische Schicht 6 angeordnet, die im folgenden als Grundstruktur-Dielektrikum bezeichnet wird. Darüber ist eine Metallschicht 1' angeordnet. Da das Grundstruktur-Dielektrikum 6 nur in den Zwischenräumen zwi-schen den Leiterbahnen 10 angeordnet ist, reicht die Metallschicht 1' zwischen ihnen bis an die Leiterbahnen 10. In diesen Bereichen 2 findet ein elektrischer Kontakt statt. Die Metallschicht ist relativ hoch ausgeführt und an ihrer Oberfläche eben. Genau über den Kontaktbereichen 2 zwischen der Metallschicht 1' und den Leiterbahnen 10 ausgerichtet, befindet sich der Lack 11 einer Lackmaske.

Fig. 2 zeigt die nächste Zwischenstufe des Herstellungsverfahrens. Die Oberfläche der Metallschicht 1' wurde anisotrop geätzt, wobei die mit dem Lack 11 versehenen Bereiche der Oberfläche von dem Ätzvorgang ausgenommen sind. Die Metallschicht 1' ist in der in Fig. 2 dargestellten Stufe bis auf das Grundstruktur-Dielektrikum 6 heruntergeätzt. Auf diese Weise sind aus der Metallschicht 1' einzelne erste Elektroden 1 entstanden. An ihren Flanken hat sich durch den Ätzvorgang eine dielektrische Schicht 3 gebildet, welche durch entsprechende Auswahl des Ätzgases und der Verfahrensparameter während des Ätzens in ihrer Zusammensetzung und Schichtdicke gezielt erzeugt wurde.

In den nachfolgenden Schritten wird der Lack 11 entfernt und eine weitere Metallschicht 5 auf die integrierte Schaltungsstruktur aufgebracht. Wie Fig. 3 zeigt, ist diese Metallschicht 5 so hoch ausgebildet, daß sie die Elektroden 1 in ihrer Höhe überragt. Sie weist eine ebene Oberfläche auf.

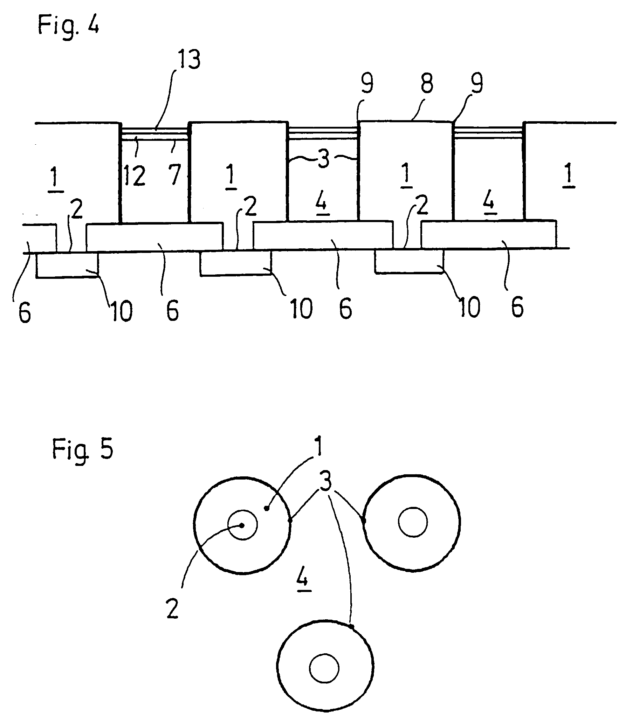

Fig. 4 verdeutlicht den weiteren Verfahrensverlauf, bei dem die Metallschicht 5 soweit zurückgeätzt wurde, daß ihre Oberfläche 7 unterhalb der Oberflächen 8 der ersten Elektroden 1 liegt. Ein oberes Ende 9 der dielektrischen Schicht 3 wird dadurch freigelegt. Durch das beschriebene Zuruckätzen der Metallschicht 5 (z.B. Wolfram) wird eine zweite Elektrode 4 erhalten, die als gemeinsame Gegenelektrode für mehrere erste Elektroden 1 dient. Auf die Oberfläche 7 der zweiten Elektrode 4 ist als elektrisch leitende Schicht eine dünne Silicidschicht 12 aufgebracht. Auf der Silicidschicht 12 befindet sich eine zweite, niederohmige, elektrisch leitende Schicht 13, welche ähnlich wie die Metallschicht 5 in einem anisotropen Ätzverfahren von den Oberflächen 8 der ersten Elektrode 1 entfernt wurde und sich lediglich über die mit Silicid versehenen Bereiche 12 der zweiten Elektrode 4 erstreckt. Die Barrierenschicht 12 und die Schicht 13 haben einen wesentlich geringeren Widerstand als die Metallschicht der zweiten Elektrode 4. Diese beiden Schichten können als Parallelschaltung von Widerständen aufgefaßt werden.

Wie Fig. 5 zeigt, sind in dieser Ausführungsform die aus den Elektroden 1 und 4 sowie der dielektrischen Schicht 3 gebildeten Kondensatoren regelmäßig angeordnet.

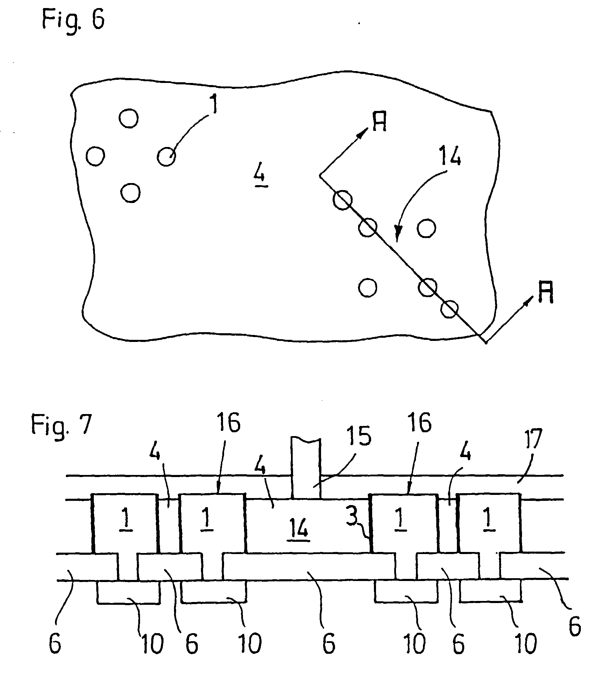

Fig. 6 zeigt die Draufsicht auf eine Anordnung aus mehreren Kondensatoren. In dem mit 14 bezeichneten Bereich weisen die benachbarten Kondensatoren einen erhöhten Abstand voneinander auf und bilden ein Anschlußfeld. In diesem Anschlußfeld 14 kann beispielsweise mit einem Bondverfahren ein Kontakt zu der zweiten Elektrode 4 der Kondensatoren hergestellt werden.

Fig. 7 verdeutlicht eine Kontaktierungsmöglichkeit zu der zweiten Elektrode 4. Die Kontaktierung erfolgt durch die Herstellung einer Bondverbindung in das Anschlußfeld 14. Der Bonddraht 15 wird im Anschlußfeld 14 fixiert, welches eine größere Oberfläche aufweist als der Zwischenbereich zwischen zwei normal beabstandeten Elektroden 1. Über diese Anordnung ist eine dielektrische Schicht 17, die als IMOX (Inter Metall Oxid) ausgebildet ist, aufgebracht. Das Anschlußfeld 14 kann als eine Art Padfenster für den Bonddraht 15 oder für ein VIA für die nächste Metallebene aufgefaßt werden.

## Patentansprüche

1. Kondensator mit einer ersten Elektrode (1), welche durch Ätzen einer Metallschicht (1') hergestellt ist, einer zweiten Elektrode (4) sowie einer dielektrischen Schicht (3) zwischen erster und zweiter Elektrode,
**dadurch gekennzeichnet,**
daß die dielektrische Schicht (3) aus einer beim Ätzen der Metallschicht (1') gebildeten polymeren Struktur und/oder Ätzprodukten des Metalls besteht.

2. Kondensator gemäß Anspruch 1,
**dadurch gekennzeichnet,**
daß die dielektrische Schicht (3) aus einer beim chemischen oder chemisch-physikalischen Trockenätzen und insbesondere beim Plasmaätzen gebildeten polymeren Struktur und/oder Ätzprodukten des Metalls besteht.

3. Kondensator gemäß Anspruch 2,
**dadurch gekennzeichnet,**
daß die dielektrische Schicht (3) eine unter Verwendung von Ätzgasen, welche halogenierte Kohlenwasserstoffe enthalten, beim Ätzen gebildete polymere Struktur umfaßt.

4. Kondensator gemäß Anspruch 2,
**dadurch gekennzeichnet,**
daß die dielektrische Schicht (3) Metalloxide und/oder Metallhalogenide umfaßt.

5. Kondensator gemäß einem der Ansprüche 1 bis 4,
**dadurch gekennzeichnet,**
daß Metallschicht (1') und erste Elektrode (1) im wesentlichen aus Wolfram, Aluminiumverbindungen oder Kupfer bestehen.

6. Kondensator nach einem der Ansprüche 1 bis 5,
**dadurch gekennzeichnet,**
daß die erste Elektrode (1) zylinderförmig ist, die dielektrische Schicht (3) in Hohlzylinderform um die Elektrode (1) herum angeordnet ist und die dielektrische Schicht (3) von der zweiten Elektrode (4) umgeben ist.

7. Kondensator nach Anspruch 6,
**dadurch gekennzeichnet,**
daß sich die Kontaktierstellen an den Enden der Elektroden (1, 4) in Richtung der Zylinderachse befinden.

8. Kondensator nach Anspruch 6 oder 7,
**dadurch gekennzeichnet,**
daß die erste Elektrode (1) auf einer Seite in Richtung der Zylinderachse über die zweite Elektrode (4) übersteht.

9. Kondensator nach einem der Ansprüche 6 bis 8,
**dadurch gekennzeichnet,**
daß auf der zweiten Elektrode (4) eine elektrisch leitende Schicht (12) angeordnet ist.

10. Kondensator nach Anspruch 9,
**dadurch gekennzeichnet,**
daß die elektrisch leitende Schicht (12) aus einem Metallsilicid besteht.

11. Kondensator nach einem der Ansprüche 9 und 10,
**dadurch gekennzeichnet,**
daß eine zusätzliche elektrisch leitende Schicht (13) auf der elektrisch leitenden Schicht (12) angeordnet ist.

12. Kondensator nach Anspruch 11,
**dadurch gekennzeichnet,**
daß die zusätzliche elektrisch leitende Schicht (13) aus Metall besteht.

13. Verfahren zur Herstellung eines Kondensators nach einem der
vorhergehenden Ansprüche,
**gekennzeichnet** durch die folgenden Schritte:
- eine Metallschicht (1') wird auf eine Grundstruktur aufgebracht;
- die Metallschicht (1') wird geätzt, so daß eine erste Elektrode (1) entsteht und auf deren dem Ätzen zugänglicher Oberfläche eine polymere Struktur und/oder Ätzprodukte des Metalls als dielektrische Schicht (3) gebildet werden;
- eine zweite Elektrode (4) wird so angebracht, daß erste (1) und zweite Elektrode (4) durch die dielektrische Schicht (3) voneinander getrennt sind.

14. Verfahren gemäß Anspruch 13,
**dadurch gekennzeichnet,**
daß die Metallschicht (1') durch chemisches oder chemischphysikalisches Trockenätzen und insbesondere durch Plasmaätzen anisotrop geätzt wird und sich die dielektrische Schicht (3) an den senkrechten Flanken der ersten Elektrode (1) ausbildet.

15. Verfahren gemäß Anspruch 13 oder 14,
**dadurch gekennzeichnet,**
daß als Ätzmittel ein Ätzgas und insbesondere ein Ätzgas eingesetzt wird, welches einen oder mehrere halogenierte Kohlenwasserstoffe, ein oder mehrere Halogene, einen oder mehrere Halogenwasserstoffe, ein oder mehrere Halogenidverbindungen des Bors, Siliciums oder Antimons oder Mischungen dieser Verbindungen umfaßt.

16. Verfahren gemäß Anspruch 14 oder 15,
**dadurch gekennzeichnet,**
daß die zweite Elektrode (4) als Metallschicht um erste Elektrode (1) und dielektrische Schicht (3) ausgebildet wird.

17. Verfahren gemäß Anspruch 16,
**dadurch gekennzeichnet,**
daß die zweite Elektrode (4), insbesondere durch Schleifen oder Ätzen, so weit abgetragen wird, daß ihre Höhe geringer ist als die Höhe der ersten Elektrode (1).

18. Verfahren gemäß Anspruch 17,
**dadurch gekennzeichnet,**
daß auf der zweiten Elektrode (4) eine elektrisch leitende Schicht (12) und gegebenenfalls eine zusätzliche elektrisch leitende Schicht (13) derart ausgebildet wird, und, insbesondere durch Schleifen oder Ätzen, so weit abgetragen wird, daß die Höhe von zweiter Elektrode (4) und elektrisch leitender Schicht (12) sowie gegebenenfalls zusätzlicher elektrisch leitender Schicht (13) geringer ist als die Höhe der ersten Elektrode (1).

19. Speicherfeld unter Verwendung von Kondensatoren nach einem
der Ansprüche 1 bis 12,
**dadurch gekennzeichnet,**
daß mehrere Kondensatoren nebeneinander angeordnet sind.

20. Speicherfeld gemäß Anspruch 19,
**dadurch gekennzeichnet,**
daß mehrere oder alle der zweiten Elektroden (4) als Metallschicht ausgebildet sind, welche mehreren oder allen ersten Elektroden (1) des Speicherfeldes als gemeinsame Gegenelektrode dient.

21. Speicherfeld nach Anspruch 20,
**dadurch gekennzeichnet,**
daß im Bereich eines Anschlußfeldes (14) der Abstand zwischen benachbarten Kondensatoren vergrößert ist und daß in dem Anschlußfeld (14) ein Bonddraht (15) zur Kontaktierung des Speicherfeldes oder zur Kontaktierung der nächsten Metallisierungslage festgebondet ist.
